# EUROPEAN PATENT APPLICATION

(11) **EP 4 708 669 A1**
(43) Date of publication of application: **11.03.2026**
(21) Application number: 24198637.1
(22) Date of filing: 05.09.2024
(51) Int. Cl.: H02P 27/06, G01R 31/34, H02P 29/024, B60P 1/00

(54) **METHOD AND SYSTEM FOR DETERMINING ELECTRIC MACHINE TYPE**

(71) Applicant: Volvo Penta Corporation, 405 08 Göteborg (SE)
(72) Inventor: LINDEMARK, Tobias, 418 72 Göteborg (SE); PROCZKOWSKI, Tomasz, 424 91 Olofstorp (SE)
(74) Representative: Valea AB

(57) **Abstract**

A method and system for determining a type of electric machine (420) comprised in a propulsion system (400) of a vehicle (700) are provided. An EMD (410) is firstly connected to a voltage source (430) until a capacitor (C1) is charged to a desired voltage level, secondly the EMD (410) is disconnected from the voltage source (430), then any two phases of a three-phase electric machine (420) are connected to the EMD (410) such that a series resonance circuit is formed by the capacitor (C1) and windings comprised in the three-phase electric machine (420). The resonance waveform of the resonance circuit across the terminals of the capacitor (C1) is monitor and the type of the electric machine (420) is determined based on the resonance characteristics of the resonance circuit.

## Description

### TECHNICAL FIELD

The disclosure relates generally to electric machines. In particular aspects, the disclosure relates to method and system for determining electric machine type. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

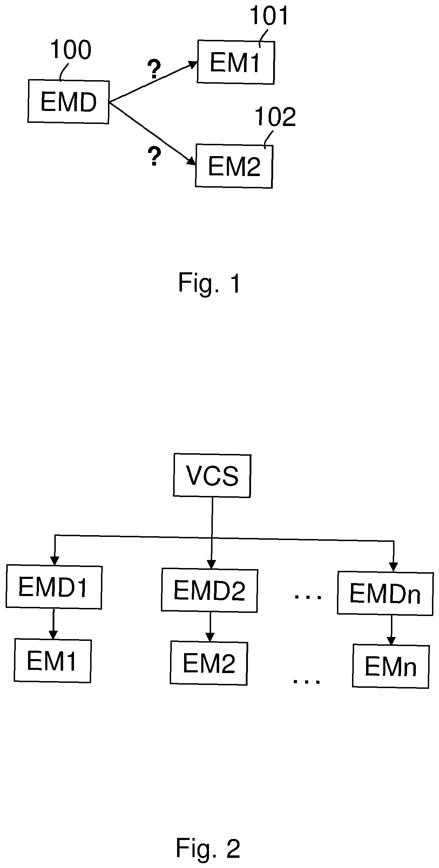

A Motor Drive System (MDS) comprises an Electric Motor Drive (EMD) and an electric motor or machine (EM) that together are used to provide operation or output such as speed and torque. These can be used in propulsion systems in vehicles to control the operation of EMs or auxiliary loads e.g. hydraulics arms etc. The MDS is essential in applications requiring precise motor control and energy efficiency. An MDS usually comprises an inverter, known as an EMD which controls one EM. There are configurations that have two or more EMD for each EM. However, it is possible that several types of electric machines can be used or controlled by the same EMD. **FIG. 1** is a schematic block diagram showing an exemplary of **EMD 101** capable of controlling two EMs, **EM1 101, EM2 102,** according to an example. The same hardware design may be used for both EM1101 and EM2 102. However, the EMD 101 can't determine which EM it is connected to or paired with. The EMD 101 must know which EM it is paired with since each EM requires its specific control software. There are limited ways of informing the EMD 101, which EM it is currently paired with. An EM usually has no logic circuits or pre- programmed software to inform the EMD 101. This is an important issue as the EMD 101 will require control software based on the type of EM it is currently paired with.

### SUMMARY

According to a first aspect of the disclosure, a computer-implemented method for determining a type of electric machine comprised in a propulsion system of a vehicle is provided. The propulsion system comprises one or more EMDs each comprising a three-phase inverter and a capacitor connected in parallel, one or more electric machines and a voltage source. The method comprises connecting, by processing circuitry of a computer system, an EMD to the voltage source until its capacitor is charged to a desired voltage level; disconnecting, by the processing circuitry, the EMD from the voltage source; connecting, by the processing circuitry, any two phases of a three-phase electric machine to the EMD such that a series resonance circuit is formed by the capacitor and windings comprised in the three-phase electric machine; monitoring, by the processing circuitry, the resonance waveform of the resonance circuit across the terminals of the capacitor; and determining, by the processing circuitry, the type of the electric machine based on the resonance characteristics of the resonance circuit. The first aspect of the disclosure may seek to detect which type of EM the EMD is currently paired with. A technical benefit may include providing an easy and secure method to detect which type of EM is currently paired to the EMD, enabling the EMD to be configured with specific control software suitable for that type of EM.

Optionally in some examples, including in at least one preferred example, connecting any two phases of a three-phase electric machine to the EMD may comprise switching on any one of the transistors in any two phases of the three-phase electric machine.

Optionally in some examples, including in at least one preferred example, the resonance characteristics of the resonance circuit may comprise frequency and/or voltage of the resonance waveform. A technical benefit may include by comparing the frequency or voltage of the resonance waveform with a pre-determined frequency or voltage representing a certain type of electric machine, the type of the EM can be easily and securely determined or detected.

Optionally in some examples, including in at least one preferred example, the method may further comprise determining, by the processing circuitry, whether there is a short-circuit between windings of each phase or between turns in each winding of the electric machine based on the resonance characteristics of the resonance circuit. A technical benefit may include providing an easy and secure method to detect both inter-phase and inter-turn faults in the electric machine.

Optionally in some examples, including in at least one preferred example, the method may further comprise configuring, by the processing circuitry, the EMD based on the type of electric machine. A technical benefit may include providing an easy and secure method to configure the EMD and enabling the specific control software to be selected and loaded to the EMD or the existing control software to be parameterized or recalibrated for this type of electric machine.

According to a second aspect of the disclosure, a computer system for implementing the method described above for determining a type of electric machine is provided. The computer system comprises a processing circuitry configured to connect an EMD to the voltage source until its capacitor is charged to a desired voltage level; The processing circuitry is further configured to disconnect the EMD from the voltage source; then the processing circuitry is further configured to connect any two phases of a three-phase electric machine to the EMD such that a series resonance circuit is formed by the capacitor and windings comprised in the three-phase electric machine. The processing circuitry is further configured to monitor a resonance waveform of the resonance circuit across the terminals of the capacitor and determine the type of the electric machine based on the resonance characteristics of the resonance circuit. The second aspect of the disclosure may seek to detect which type of EM the EMD is currently paired with. A technical benefit may include providing an easy and secure system to detect which type of EM is currently paired to the EMD, enabling the EMD to be configured with specific control software suitable for that type of EM.

Optionally in some examples, including in at least one preferred example, the processing circuitry may be further configured to switch on any one of the transistors in any two phases of the three-phase electric machine such that a series resonance circuit is formed by the capacitor and windings comprised in the three-phase electric machine.

Optionally in some examples, including in at least one preferred example, the resonance characteristics of the resonance circuit may comprise frequency and/or voltage of the resonance waveform. A technical benefit may include by comparing the frequency or voltage of the resonance waveform with a pre-determined frequency or voltage representing a certain type of electric machine, the type of the EM can be easily and securely determined or detected.

Optionally in some examples, including in at least one preferred example, the processing circuitry may further be configured to determine whether there is a short-circuit between windings of each phase or between turns in each winding of the electric machine based on the resonance characteristics of the resonance circuit. A technical benefit may include providing an easy and secure system to detect both inter-phase and inter-turn faults in the electric machine.

Optionally in some examples, including in at least one preferred example, the processing circuitry may further be configured to configure the EMD based on the type of electric machine. A technical benefit may include providing an easy and secure system to configure the EMD and enabling the specific control software to be selected and loaded to the EMD or the existing control software in the EMD to be parameterized or recalibrated for this type of electric machine.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units or system, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is a schematic block diagram showing an exemplary of EMD capable of controlling two EMs according to an example.
**FIG. 2** is a schematic block diagram showing an exemplary of EMD and EMs combination in view of software according to an example.
**FIG. 3** is a schematic block diagram showing an EMD signal connector according to an example.
**FIG. 4** is a schematic block diagram showing an exemplary of an EMD with EM according to an example.
**FIG. 5** is a flow chart of an exemplary method for determining the type of an EM;
**FIG. 6** is a schematic block diagram showing an exemplary of a resonant circuit formed by components in EMD and EM according to an example.
**FIG. 7** is a schematic block diagram showing an exemplary vehicle.
**FIG. 8** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

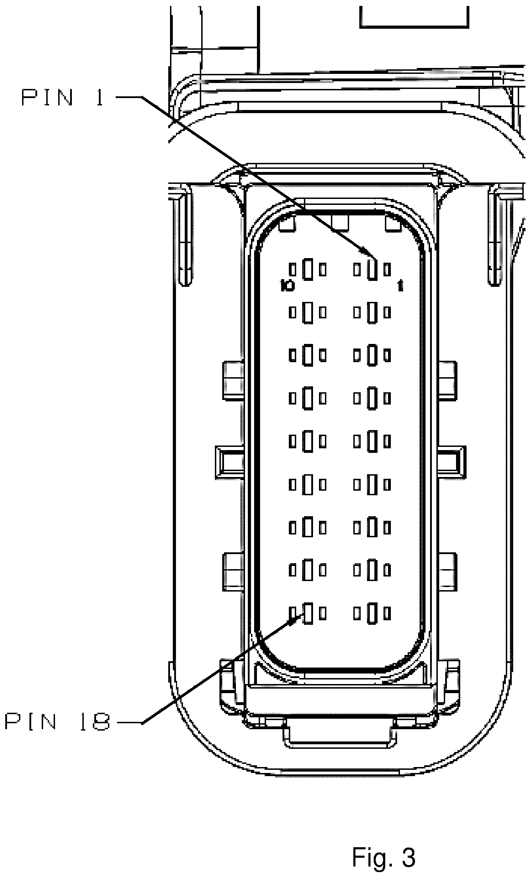

An MDS in a vehicle typically comprises an EMD and an EM. The EMD may have the same hardware design for multiple MDS:s while the EM may have several different designs each used with a different MDS with a different purpose. Each EM needs its specific control software. To inform the EMD which EM it is currently paired with, software packages may be prepared and hard coded for a limited set of EMD and EM combinations. **FIG. 2** is schematic block diagram showing an exemplary of EMD and EMs combination in view of software according to an example, which is referred as a motor position in software. A motor position in software is a predefined combination of EMD software and EM, such as software EMD1 is for EM1, software EMD2 is for EM2, ... software EMDn is for EMn. Each EMD software and EM combination receives communication requests from a vehicle control system **VCS** of the vehicle. Each request has an identification (ID) encoded into it. This ID needs to match the ID designated to the EMD in hardware to prevent the requests such as the speed and torque requests being received by an incorrect EMD software and EM combination. **Fig. 3** is schematic block diagram showing an EMD signal connector with a set of pins, e.g. **PIN 1** to **PIN 18** to show motor positions in view of hardware according to an example. Motor position in hardware is made in signal harness. The EMD signal connector has a set of pins reserved for setting ID designated to the EMD. The ID is set by connecting some of the pins to supply voltage and some to ground. As an example, 4 pins may be set to create an ID for each EMD software and EM combination, where each pin represents a bit and where the leftmost bit is the most significant bit. For example, if pin 1 is the most significant bit, pin 2 the second most significant bit etc., pins 1 and 2 may be connected to ground and pins 3 and 4 may be connected to supply voltage, a binary number 0011 can be created, where 1 means the pin is connected to supply voltage and 0 means the pin is connected to ground. Decoding the binary number 0011 results in an ID of 3 (bin 0011 = dec 3), therefore only the 3^{rd} EMD software and EM combination, i.e. EMD3-EM3, receives the requests with the ID 0011 encoded into it, and the requests can be correctly applied by the right software in EMD to the right EM.

If a mix up in EMs as well as signal harness between e.g. EM1 and EM2, has been made, e.g. software EMD1 is paired to EM2, the EMD will not be aware of this and try to apply the torque request for EM1 on the EM2 which is wrong EM.

By visually checking, by e.g. the manufacture of Original Equipment Manufacturing (OEM), e.g. the Part Number of EM, what type of EM each EMD is paired with may be confirmed. Using hard wiring the pin-out, the EMD can be informed what ID the paired EM has. Furthermore, these IDs need to be linked to the correct motor position in the software, i.e. the control software in EMD should match the EM ID and type. However, this method is complicated, troublesome, time consuming and not error prevention. The OEM manufacture can still make mistakes and place an EM on the wrong "position", either in hardware or in software or in both hardware and software.

Exchanging EM type requires also a new harness to the EMD. Further, if all possible combinations of EMD software and EM have to be covered, a lot of effort is required and a large amount of data combinations that have to be managed at the OEM manufacture.

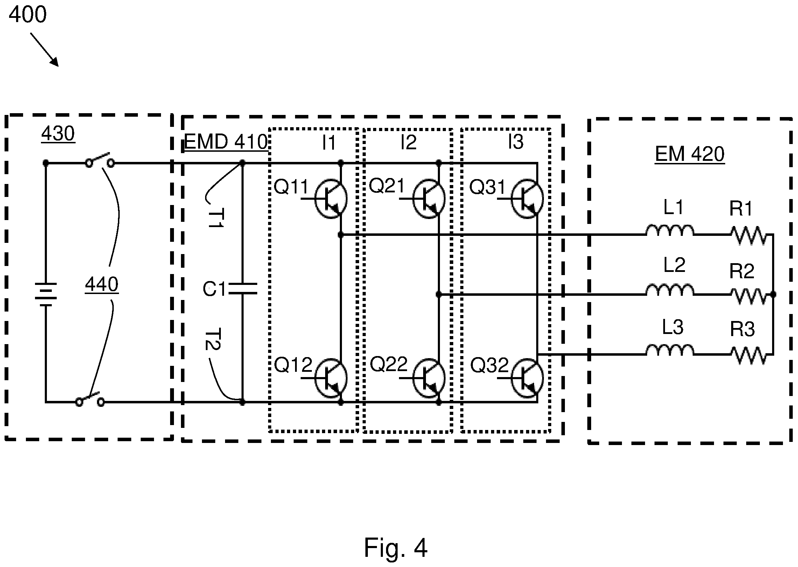

**Fig. 4** is a schematic block diagram showing an example of a propulsion system **400** for a vehicle. The propulsion system 400 comprises one or more EMD, where an **EMD 410** paired with an **EM 420** is shown. The EMD 410 comprises a three-phase inverter I**1, I2, I3** and a capacitor **C1** connected in parallel. A DC voltage source **430** e.g. a battery pack, a charger, a fuel cell, a generator etc., provides power to the EMD 410 and can be connected to the EMD 410 through one or more switches **440.** The three-phase inverter I1, I2, I3 comprised in the EMD 410 each comprising a first and a second transistors, i.e. the first phase inverter I1 comprises a first transistor **Q11** and a second transistor **Q12,** the second phase inverter 12 comprises a first transistor **Q21** and a second transistor **Q22** and the third phase inverter 13 comprises a first transistor **Q31** and a second transistor **Q32.** The EM 420 is represented by a three-phase inductor-resistance equivalent circuit, representing windings comprised in the EM 420. The first phase of EM 420 comprises a first winding represented by an inductor-resistance equivalent circuit comprising a first inductor **L1** and a first resistance **R1**, the second phase of EM 420 comprises a second winding represented by an inductor-resistance equivalent circuit comprising a second inductor **L2** and a second resistance **R2,** and the third phase of EM 420 comprises a third winding represented by an inductor-resistance equivalent circuit comprising a third inductor **L3** and a third resistance **R3.**

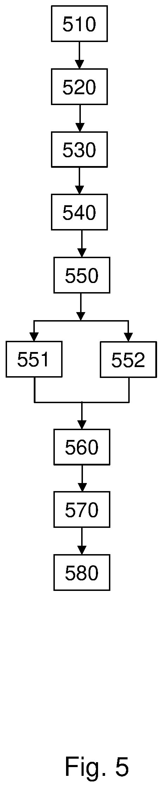

An example method for determining a type of EM comprised in a propulsion system for a vehicle as shown in Fig. 4 will be described with reference to **Fig.5****.** The method comprises one or more of the following actions which may be performed in any suitable order. The method may be performed by a processing circuitry of a computer system comprised in the vehicle.

### Action 510

Connecting the EMD 410 to the voltage source 430 by e.g. closing the switches 440, until the capacitor C1 is charged to a desired voltage level, e.g. to the voltage level of voltage source 430.

### Action 520

Disconnecting the EMD 410 from the voltage source 430, by e.g. opening the switches 440.

### Action 530

Connecting any two phases of the EM 420 to the EMD 410 such that a series resonance circuit is formed by the capacitor C1 and windings comprised in the EM 420. This may be achieved by switching on any one of the transistors in any two phases of the three-phase electric machine 420.

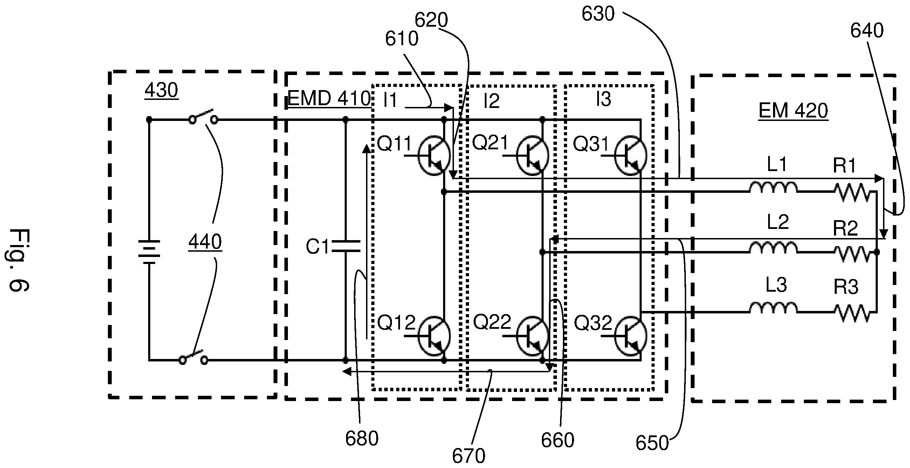

For example, one can connect the first and second phases of the EM 420 by switching on the first transistor Q11 in the first phase I1 of the three-phase inverter and switching on the second transistor Q22 in the second phase I2 of the three-phase inverter, or by switching on the first transistor Q21 in the second phase I2 and the second transistor Q12 in the first phase I1, such that the first and second windings L1, R1, R2, L2 comprised in the three-phase EM 420 are connected in series with the capacitor C1 to form a series resonance circuit. An exemplary series resonance circuit is shown in **Fig.6** with arrows **610-680** showing current flow in the resonance circuit.

For example, one can connect the first and third phases of the EM 420 by switching on the first transistor Q11 in the first phase I1 of the three-phase inverter and switching on the second transistor Q32 in the third phase I3 of the three-phase inverter, or by switching on the first transistor Q31 in the third phase I3 and the second transistor Q12 in the first phase I1, such that the first and third windings L1, R1, R3, L3 comprised in the three-phase EM 420 are connected in series with the capacitor C1 to form a series resonance circuit.

For example, one can connect the second and third phases of the EM 420 by switching on the first transistor Q21 in the second phase I2 of the three-phase inverter and switching on the second transistor Q32 in the third phase I3 of the three-phase inverter, or by switching on the first transistor Q31 in the third phase I3 and the second transistor Q22 in the second phase I2, such that the second and third windings L2, R2, R3, L3 comprised in the three-phase EM 420 are connected in series with the capacitor C1 to form a series resonance circuit.

### Action 540

Monitoring the resonance waveform of the resonance circuit across terminals **T1**, **T2** of the capacitor C1.

### Action 550

Determining the type of the electric machine based on the resonance characteristics of the resonance circuit. Some exemplary types of EM may be e.g. permanent-magnet synchronous motor (PMSM), induction machine, reluctance machine, electrically excited synchronous machine etc.

The resonance characteristics of the resonance circuit may be the frequency of the resonance waveform. The energy stored in capacitor C1 will resonate with a certain frequency based on the characteristics, i.e. the winding's inductance and resistance, of the EM 420. The resonance frequency can be measured and compared to the resonance frequency representing a certain type of electric machine. The resonance frequency representing a certain type of electric machine may be predetermined by simulations, measurements or obtained from the product provider. Many manufacturers perform measurements as quality control before shipping EM to customer and a waveform is established as basic data of the EM. Therefore, determining the type of the electric machine based on the resonance characteristics of the resonance circuit may comprise:

### Action 551

Comparing the frequency of the resonance waveform with a frequency representing a certain type of electric machine.

The resonance characteristics of the resonance circuit may be voltage of the resonance waveform. The initial peak voltage of the resonance waveform is going to be determined by the voltage source voltage. The voltage amplitude is going to decrease over time depending on the electric machine 420 connected. Since different electric machines have different resistances, the energy in the capacitor will dissipate over different time frames as heat. By monitoring the voltage of the resonance waveform, one can determine the type of the EM.

Therefore, determining the type of the electric machine based on the resonance characteristics of the resonance circuit may comprise:

### Action 552

Comparing the voltage of the resonance waveform with a pre-determined voltage representing a certain type of electric machine.

After the type of the EM has been determined, the method may further comprise:

### Action 560

Configuring EMD 410 based on the type of EM, such as selecting and loading software for the EMD 410 based on the type of the electric machine, or parametrizing, recalibrating already available software e.g. changing a parameter within the current software without downloading the whole software, etc.

According to some examples, the method described above for determining the type of EM can also be used for determining EM health, such as whether there is a short-circuit between windings or between turns in the winding of the electric machine 420. The method may further comprise one or more of the following actions.

### Action 570

Determining whether there is a short-circuit between windings of each phase of the electric machine 420 based on the resonance characteristics of the resonance circuit. Since the windings in the electric machine 420 form coils, a short circuit between the coils is going to reduce the total inductance and resistances of the coils. This impacts the appearance, i.e. the frequency and voltage of the resonance waveform. By inspecting the resonance waveform, one can detect if there is a short-circuit between windings, i.e. an inter-phase fault.

### Action 580

Determining whether there is a short-circuit between turns in each winding of the electric machine 420 based on the resonance characteristics of the resonance circuit. As discussed above, the windings in the electric machine 420 form coils, a short circuit between turns within a coil is going to reduce the inductance and resistance of the coil. This impacts the appearance, e.g. the frequency and voltage of the resonance waveform. By inspecting the resonance waveform, one can detect if there is a short-circuit between turns, i.e. an inter-turn fault, similar as a quality check when manufacturing new electric machines called "surge testing".

The method described above for determining the type of EM may apply to any alternating current (AC) EM or motor with winding stator, such as permanent-magnet synchronous motor (PMSM), induction machine, reluctance machine, electrically excited synchronous machine etc.

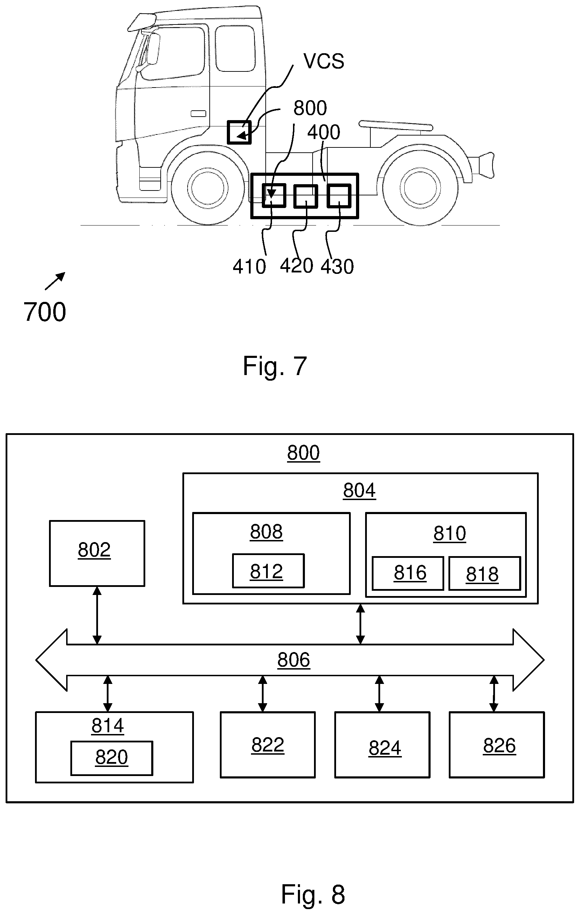

**FIG. 7** is an exemplary block diagram of a vehicle **700** in which the method for determining the type of EM may be implemented according to an example. The vehicle 700 comprises a propulsion system 400 comprising one or more EMD e.g. EMD 410 paired with an EM 420 and a voltage source 430. The vehicle 700 further comprises a computer system **800** for implementing examples disclosed herein. The computer system **800** may be implemented or comprised wholly or partly in VCS and/or in EMD 410. The method Actions 510-580 may be performed by the computer system 800 in the VCS or in the EMD 410. The method Actions 510-580 may also be performed by the computer system 800 in the VCS and the EMD 410, i.e. the responsibilities may be split to the control systems in VCS and EMD 410. For example, the VCS may inform the EMD 410 of the waveforms to compare to, EMD 410 may perform the comparison with the actual measured EM.

**FIG. 8** is a schematic diagram of a computer system **800** for implementing examples disclosed herein. The computer system 800 comprises a processing circuitry **802** configured to determine a type of electric machine.

The processing circuitry 802 is configured to connect the EMD 410, e.g. by the processing circuitry 802 being configured to switch on the switch 440, to the voltage source 430 until its capacitor C1 is charged to a desired voltage level. The processing circuitry 802 is configured to disconnect, e.g. by the processing circuitry 802 being configured to switch off the switch 440 the EMD 410 from the voltage source 430. The processing circuitry 802 is configured to connect any two phases of the three-phase electric machine 420 to the EMD 410, e.g. by the processing circuitry 802 being configured to switch on any one of the transistors in any two phases of the three-phase electric machine 420, such that a series resonance circuit is formed by the capacitor C1 and windings comprised in the three-phase electric machine 420.

The processing circuitry 802 is configured to monitor the resonance waveform of the resonance circuit across the terminals of the capacitor C1 and determine the type of the electric machine 420 based on the resonance characteristics of the resonance circuit.

The processing circuitry 802 may be configured to compare the frequency of the resonance waveform with a pre-determined frequency representing a certain type of electric machine; or compare the voltage of the resonance waveform with a pre-determined voltage representing a certain type of electric machine.

The processing circuitry 802 may be further configured to configure the EMD 410 based on the type of electric machine.

The processing circuitry 802 may be further configured to determine whether there is a short-circuit between windings of each phase of the electric machine 420 based on the resonance characteristics of the resonance circuit.

The processing circuitry 802 may be further configured to determine whether there is a short-circuit between turns in each winding of the electric machine 420 based on the resonance characteristics of the resonance circuit.

The computer system **800** is adapted to execute instructions from a computer-readable medium to perform these and/or any of the functions or processing described herein. The computer system **800** may be connected (e.g., networked) to other machines in a LAN (Local Area Network), LIN (Local Interconnect Network), automotive communication protocol, an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806.** The computer system **800** may include at least one computing device having the processing circuitry **802.** The system bus **806** provides an interface for system components including, but not limited to, the memory **804** and the processing circuitry **802.** The processing circuitry **802** may include any number of hardware components for conducting data or signal processing or for executing computer code stored in memory **804.** The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-access memory (RAM)), or any other medium which can be used to carry or store desired program code in the form of machine-executable instructions or data structures and which can be accessed by a computer or other machine with processing circuitry **802.** A basic input/output system (BIOS) **812** may be stored in the non-volatile memory **808** and can include the basic routines that help to transfer information between elements within the computer system **800.**

The computer system **800** may further include or be coupled to a non-transitory computer-readable storage medium such as the storage device **814,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device
interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Some examples are listed here.
**Example 1:** A computer-implemented method for determining a type of electric machine (420) comprised in a propulsion system (400) of a vehicle, wherein the propulsion system (400) comprises one or more Electric Motor Drive, EMD, (410) each comprising a three-phase inverter (I1, I2, I3) and a capacitor (C1) connected in parallel, one or more electric machines (420) and a voltage source (430), the method comprising:
   connecting (510), by a processing circuitry (802) of a computer system (800), an EMD (410) to the voltage source (430) until its capacitor (C1) is charged to a desired voltage level;
   disconnecting (520), by the processing circuitry (800), the EMD (410) from the voltage source (430);
   connecting (530), by the processing circuitry (800), any two phases of a three-phase electric machine (420) to the EMD (410) such that a series resonance circuit is formed by the capacitor (C1) and windings (L1, R1, L2, R2, L3, R3) comprised in the three-phase electric machine (420);
   monitoring (540), by the processing circuitry (800), the resonance waveform of the resonance circuit across the terminals of the capacitor (C1); and
   determining (550), by the processing circuitry (800), the type of the electric machine (420) based on the resonance characteristics of the resonance circuit.
**Example 2:** The method according to Example 1, wherein connecting (530), by the processing circuitry (800), any two phases of a three-phase electric machine (420) to the EMD (410) comprises switching on any one of the transistors (Q11/Q12, Q21/Q22, Q31/Q33) in any two phases (I1/I2, I1/I3, I2/I3) of the three-phase inverter.
**Example 3:** The method according to any one of Examples 1-2, wherein the resonance characteristics of the resonance circuit comprises frequency and/or voltage of the resonance waveform.
**Example 4:** The method according to any one of Examples 1-3, wherein determining (550), by the processing circuitry (800), the type of the electric machine based on the resonance characteristics of the resonance circuit comprising:
   comparing (551), by the processing circuitry (800), the frequency of the resonance waveform with a pre-determined frequency representing a certain type of electric machine, or
   comparing (552), by the processing circuitry (800), the voltage of the resonance waveform with a pre-determined voltage representing a certain type of electric machine.
**Example 5:** The method according to any one of Examples 1-4, further comprising:
   configuring (560), by the processing circuitry (800), the EMD based on the type of electric machine.
**Example 6:** The method according to Example 5, wherein configuring the EMD based on the type of the electric machine comprises selecting and loading software to the EMD, or parametrizing or recalibrating existing software in the EMD based on the type of the electric machine.
**Example 7:** The method according to any one of Examples 1-6, further comprising:
   determining (570), by the processing circuitry (800), whether there is a short-circuit between windings of each phase of the electric machine based on the resonance characteristics of the resonance circuit, or
   determining (580), by the processing circuitry (800), whether there is a short-circuit between turns in each winding of the electric machine based on the resonance characteristics of the resonance circuit.
**Example 8:** The method according to any one of Examples 1-7, wherein the type of one or more electric machine is any one of an alternating current, AC, electric machine or motor with winding stator, permanent-magnet synchronous motor, PMSM, induction machine, reluctance machine, electrically excited synchronous machine.
**Example 9:** A computer system (800) comprising processing circuitry (802) configured to determine a type of electric machine comprised in a propulsion system (400) of a vehicle (700), wherein the propulsion system (400) comprises one or more Electric Motor Drive, EMD, (410) each comprising a three-phase inverter (I1, I2, I3) and a capacitor (C1) connected in parallel, one or more electric machines (420) and a voltage source (430), wherein the processing circuitry (802) is configured to:
   connect an EMD (410) to the voltage source (430) until its capacitor (C1) is charged to a desired voltage level;
   disconnect the EMD (410) from the voltage source (430);
   connect any two phases of a three-phase electric machine (420) to the EMD (410) such that a series resonance circuit is formed by the capacitor (C1) and windings comprised in the three-phase electric machine (420);
   monitor the resonance waveform of the resonance circuit across the terminals of the capacitor (C1); and
   determine the type of the electric machine (420) based on the resonance characteristics of the resonance circuit.
**Example 10:** The computer system (800) according to Example 9, wherein the processing circuitry (802) is configured to switch on any one of the transistors (Q11/Q12, Q21/Q22, Q31/Q33) in any two phases (I1/I2, I1/I3, I2/I3) of the three-phase inverter to connect two phases of the three-phase electric machine (420) to the EMD (410).
**Example 11:** The computer system (800) according to any one of Examples 9-10, wherein the processing circuitry (802) is configured to:
   compare the frequency of the resonance waveform with a pre-determined frequency representing a certain type of electric machine; or
   compare the voltage of the resonance waveform with a pre-determined voltage representing a certain type of electric machine.
**Example 12:** The computer system (800) according to any one of Examples 9-11, wherein the processing circuitry (802) is further configured to:
   configure the EMD (410) based on the type of electric machine.
**Example 13:** The computer system (800) according to any one of Examples 9-12, wherein the processing circuitry (802) is further configured to:
   determine whether there is a short-circuit between windings of each phase of the electric machine (420) based on the resonance characteristics of the resonance circuit, or
   determine whether there is a short-circuit between turns in each winding of the electric machine (420) based on the resonance characteristics of the resonance circuit.
**Example 14:** A vehicle (700) comprising the computer system (800) of any of Examples 9-13.
**Example 15:** The vehicle (700) according to Example 14 further comprising a propulsion system (400) comprising one or more Electric Motor Drive, EMD, (410), one or more electric machines (420) and a voltage source (430).
**Example 16:** A computer program product (814) comprising program code (820) for performing, when executed by the processing circuitry (802), the method of any one of claims 1-8.
**Example 17:** A non-transitory computer-readable storage medium (814) comprising instructions, which when executed by the processing circuitry (802), cause the processing circuitry (802) to perform the method of any one of claims 1-8.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer-implemented method for determining a type of electric machine (420) comprised in a propulsion system (400) of a vehicle, wherein the propulsion system (400) comprises one or more Electric Motor Drive, EMD, (410) each comprising a three-phase inverter (I1, I2, I3) and a capacitor (C1) connected in parallel, one or more electric machines (420) and a voltage source (430), the method comprising:
connecting (510), by a processing circuitry (802) of a computer system (800), an EMD (410) to the voltage source (430) until its capacitor (C1) is charged to a desired voltage level;
disconnecting (520), by the processing circuitry (800), the EMD (410) from the voltage source (430);
connecting (530), by the processing circuitry (800), any two phases of a three-phase electric machine (420) to the EMD (410) such that a series resonance circuit is formed by the capacitor (C1) and windings (L1, R1, L2, R2, L3, R3) comprised in the three-phase electric machine (420);
monitoring (540), by the processing circuitry (800), the resonance waveform of the resonance circuit across the terminals of the capacitor (C1); and
determining (550), by the processing circuitry (800), the type of the electric machine (420) based on the resonance characteristics of the resonance circuit.

2. The method according to claim 1, wherein connecting (530), by the processing circuitry (800), any two phases of a three-phase electric machine (420) to the EMD (410) comprises switching on any one of the transistors (Q11/Q12, Q21/Q22, Q31/Q33) in any two phases (I1/I2, I1/I3, I2/I3) of the three-phase inverter.

3. The method according to any one of claims 1-2, wherein the resonance characteristics of the resonance circuit comprises frequency and/or voltage of the resonance waveform.

4. The method according to any one of claims 1-3, wherein determining (550), by the processing circuitry (800), the type of the electric machine based on the resonance characteristics of the resonance circuit comprising:
comparing (551), by the processing circuitry (800), the frequency of the resonance waveform with a pre-determined frequency representing a certain type of electric machine, or
comparing (552), by the processing circuitry (800), the voltage of the resonance waveform with a pre-determined voltage representing a certain type of electric machine.

5. The method according to any one of claims 1-4, further comprising:
configuring (560), by the processing circuitry (800), the EMD based on the type of electric machine.

6. The method according to claim 5, wherein configuring the EMD based on the type of the electric machine comprises selecting and loading software to the EMD, or parametrizing or recalibrating existing software in the EMD based on the type of the electric machine.

7. The method according to any one of claims 1-6, further comprising:
determining (570), by the processing circuitry (800), whether there is a short-circuit between windings of each phase of the electric machine based on the resonance characteristics of the resonance circuit, or
determining (580), by the processing circuitry (800), whether there is a short-circuit between turns in each winding of the electric machine based on the resonance characteristics of the resonance circuit.

8. The method according to any one of claims 1-7, wherein the type of one or more electric machine is any one of an alternating current, AC, electric machine or motor with winding stator, permanent-magnet synchronous motor, PMSM, induction machine, reluctance machine, electrically excited synchronous machine.

9. A computer system (800) comprising processing circuitry (802) configured to determine a type of electric machine comprised in a propulsion system (400) of a vehicle (700), wherein the propulsion system (400) comprises one or more Electric Motor Drive, EMD, (410) each comprising a three-phase inverter (I1, I2, I3) and a capacitor (C1) connected in parallel, one or more electric machines (420) and a voltage source (430), wherein the processing circuitry (802) is configured to:
connect an EMD (410) to the voltage source (430) until its capacitor (C1) is charged to a desired voltage level;
disconnect the EMD (410) from the voltage source (430);
connect any two phases of a three-phase electric machine (420) to the EMD (410) such that a series resonance circuit is formed by the capacitor (C1) and windings comprised in the three-phase electric machine (420);
monitor the resonance waveform of the resonance circuit across the terminals of the capacitor (C1); and
determine the type of the electric machine (420) based on the resonance characteristics of the resonance circuit.

10. The computer system (800) according to claim 9, wherein the processing circuitry (802) is configured to switch on any one of the transistors (Q11/Q12, Q21/Q22, Q31/Q33) in any two phases (I1/I2, I1/I3, I2/I3) of the three-phase inverter to connect two phases of the three-phase electric machine (420) to the EMD (410).

11. The computer system (800) according to any one of claims 9-10, wherein the processing circuitry (802) is configured to:
compare the frequency of the resonance waveform with a pre-determined frequency representing a certain type of electric machine; or
compare the voltage of the resonance waveform with a pre-determined voltage representing a certain type of electric machine.

12. The computer system (800) according to any one of claims 9-11, wherein the processing circuitry (802) is further configured to:
configure the EMD (410) based on the type of electric machine.

13. The computer system (800) according to any one of claims 9-12, wherein the processing circuitry (802) is further configured to:
determine whether there is a short-circuit between windings of each phase of the electric machine (420) based on the resonance characteristics of the resonance circuit, or
determine whether there is a short-circuit between turns in each winding of the electric machine (420) based on the resonance characteristics of the resonance circuit.

14. A vehicle (700) comprising the computer system (800) of any one of claims 9-13.

15. The vehicle (700) according to claim 14 further comprising a propulsion system (400) comprising one or more Electric Motor Drive, EMD, (410), one or more electric machines (420) and a voltage source (430).
